# EUROPEAN PATENT APPLICATION

(11) **EP 2 996 446 A1**
(43) Date of publication of application: **16.03.2016**
(21) Application number: 14290297.2
(22) Date of filing: 12.09.2014
(51) Int. Cl.: H05K 1/02, H05K 1/14

(54) **High speed routing module**

(71) Applicant: ALCATEL LUCENT, 92100 Boulogne-Billancourt (FR)
(72) Inventor: Brachmann, Markus, 70435 Stuttgart (DE); Goetz, Hans-Joachim, 70435 Stuttgart (DE); Keck, Michael, 70435 Stuttgart (DE)
(74) Representative: Reichl, Wolfgang

(57) **Abstract**

A printed circuit board, PCB, device (10) comprises:
- a first PCB module (4),
- a second PCB module (11), and
- at least two electrical components (2, 5) mounted on the first PCB module (4), wherein a signal from a first one of the electrical components (2) to a second one of the electrical components (5) is routed via the second PCB module (11).

## Description

### Background

This document relates to a printed circuit board with electrical routing networks, wherein a small percentage of the electrical routing networks is used for high speed data transfer.

Complex telecommunication equipment boards typically have several thousand electrical nets. The majority of these nets are low speed data nets or power nets. A small percentage, usually below 10% of the overall net count, is dedicated to high speed data nets, for transferring data e.g. at more than 1 Gbit/s. However, despite making up only a small portion of the overall net count, high speed data nets place a large number of layout and design restrictions on the whole board, due to the need for special substrate materials and special techniques such as back-drilling of connecting through-holes (vias), which are used for electrically connecting a surface of the printed circuit board with an electrical trace provided in an internal layer of a multilayer printed circuit board, in order to ensure signal integrity at high data rates and high frequencies.

There is thus a need to provide an improved printed circuit board device which allows for high speed data routing while decreasing the complexity, cost and layout restrictions of the board.

### Summary

According to an aspect, a printed circuit board, PCB, device comprises a first PCB module, a second PCB module, and at least two electrical components mounted on the first PCB module. An electrical component may be an electronic component such as an Integrated Circuit (IC) or an electromechanical component such as a connector. A signal from a first one of the electrical components to a second one of the electrical components is routed via conductive traces of the second PCB module. Thus, a signal originating at the first electrical component mounted on the first PCB module may be routed through a first portion of the first PCB module to a first connecting element, such as e.g. a first ball grid array (BGA), further on to the second PCB module and along a trace route provided in the second PCB module. Then, the signal could be routed from the second PCB module via a second connecting element, such as e.g. a second BGA, through a second portion of the first PCB module to the second electrical component mounted on the first PCB module.

Therein, the two PCB modules may be provided as parallel, planar PCB modules, each comprising a number of layers of respective substrate material and conductive material. Thus, the overall height of the PCB device is not significantly increased due to the provision of the second PCB module. Generally, one surface of a PCB device is designated for the provision of passive components and of IC components with a low height and weight. If the second PCB module is provided so that its height, when connected to the first PCB module, is less than the maximum height designated for components on the respective surface of the PCB device, the overall thickness of the PCB device is not increased due to the provision of the second PCB module. Thus, the presence of the second PCB module does not change the overall dimensions and geometry of the PCB device compared to the requirements of a defined (and possibly standardized) slot for inserting the PCB device into telecommunications equipment. In particular, the PCB device including the second PCB module stays within the typical size (e.g. height) requirements for PCB module as used in electronic equipment. In other words, the PCB device according to embodiments can thus replace a prior art PCB device and can be used in the same rack, i.e. without the need to redesign any slots, interfaces or housing dimensions of electronic equipment that is to accommodate the PCB device. This means that the PCB device according to embodiments fits into standardized slots which may e.g. be provided in telecommunication equipment.

According to embodiments, the second PCB module may be flexible and may be curved relative to a surface of the first PCB module. Thus, differing respective thermal expansion behavior of the first and second PCB modules may be accommodated by deformation of the flexible second PCB module.

According to embodiments, the at least two electrical components may be positioned on a first side of the first PCB module and the second PCB module may be positioned on a second side of the PCB module opposite the first side. Thus, the first side of the first PCB module is freely available for mounting electrical components, while the second PCB module is provided on the opposite side of the first PCB module. This arrangement facilitates manufacturing, as e.g. the solder connections to the at least two electrical components can be provided at the same side of the first PCB module and can be processed simultaneously. Hence, electrical components can freely be fitted to at least one side of the first PCB module, such that the presence of the second PCB module does not affect the assembly of (at least one side of) the first PCB module when compared to a prior art PCB device.

According to embodiments, the at least two electrical components may be positioned on a first side of the first PCB module and the second PCB module may be positioned on the first side of the PCB module. With this configuration, a signal may be routed from the first electrical component along a trace of the second PCB module to the second electrical component without the need for any via connections through the first PCB module.

According to embodiments, the second PCB module comprises a different substrate material than the first PCB module. Therein, the second PCB module may e.g. comprise a special high speed /low loss substrate material wherein material properties such as the dielectric constant, dielectric loss or damping factor are substantially constant throughout a wide range of frequencies. Hence, the overall manufacturing costs of the PCB device are reduced since the expensive high speed/low loss substrate material is only needed for the second PCB module which may be smaller in size than the first PCB module.

The second PCB module may be adapted for routing signals with a frequency content exceeding 1GHz and/or a data rate of at least 1 Gbit/s. Since the second PCB module may be designed as a PCB module optimized for routing high speed signals, even higher data rates may be achieved.

If via holes are provided in a PCB module, via stubs may be present which generate a discontinuity to the signal path and thus an interference signal. A via stub is a part of a via hole that extends beyond the plane of the trace inside the PCB module, so that the via stub is not used for signal transmission but may have detrimental effects at high frequencies. In order to minimize the negative influence of via stubs when connecting electrical routing nets provided inside the second PCB module to connection areas on the surface of the second PCB module, the second PCB module may comprise fewer layers than the first PCB module. This also reduces the manufacturing cost of the second PCB module.

According to embodiments, the second PCB module may have an overall thickness of less than 1 mm, particularly of less than 0.8 mm. In general the thickness of the second PCB module may depend upon the number and extent of trace routes that are to be provided by the second PCB module and on the signal frequency content. Therein, an embodiment of a second PCB module which is adapted for transmission of 1 GHz signals may be designed such that its overall thickness is 1 mm or more, whereas an embodiment of a second PCB module which is adapted for transmission of 30 GHz signals may be designed such that its overall thickness does not exceed 800 µm. With a thin second PCB module, the manufacturing cost of the overall PCB device can be lowered even if the second PCB module is manufactured using costly high speed/low loss substrate materials. Further, the negative effects of via stubs on signal integrity are negligible at low thicknesses, so that it is not necessary to use back drilling techniques on via stubs in the second PCB module.

The second PCB module may comprise less than 10 layers or even as few as 4-6 layers in order to achieve the low thickness described above.

According to embodiments, the first and second electrical components may be located on a first side of the first PCB module, and the second PCB module may be located on a second side of the first PCB module. The signal from the first to the second electrical component may be routed along a first via connection through the first PCB module from the first electrical component to the second PCB module and may be routed along a second via connection through the first PCB module from the second PCB module to the second electrical component. The signals are routed through the complete first PCB module onto the other side, so that no via stubs are present in the first PCB module. Since via stubs may negatively affect the signal integrity at high data rates, the above-described arrangement provides a high signal integrity for the routing of high speed signals through the second PCB module.

The dimensions and shape of the second PCB module may be selected so that the overall surface area of the second PCB module is minimized while providing the connection and routing layout required by the electrical components mounted on the first PCB module.

The second PCB module may comprise at least two connection portions for connecting the second PCB module to the first PCB module. Alternatively, the connection portions for connecting the first and second PCB modules may be provided on the first PCB module, depending on the manufacturing process which may e.g. dictate that connection portions should be only provided on a single side of any PCB module.

The connection portions of the second PCB module to the first PCB module may be done via BGA ball connections in order to facilitate manufacturing of the PCB device. Other electrical connection mechanisms may be contemplated.

The second PCB module may be provided with at least two connection portions and at least one routing portion for routing signals from a first connection portion to a second connection portion. The number of connection portions and routing portions provided in the second PCB module may be adapted according to the high speed trace route requirements of the electrical components mounted on the first PCB module. Further, a standardized second PCB module with a defined number of connecting and routing options may be provided which may be connected to a variety of different first PCB modules.

According to a further aspect, a method for manufacturing a printed circuit board device comprises providing a first and a second PCB module, connecting the second PCB module to the first PCB module, and mounting at least two electrical components on the first PCB module. The method further comprises providing a trace for routing a signal from a first one of the electrical components to a second one of the electrical components via the second PCB module.

The method may comprise providing the second PCB module on another side to the side where electrical components are mounted, or on the same side where electrical components are mounted. In general, adding the second PCB module does not prevent mounting electrical components on the same side where the second PCB is connected, in particular if the second PCB module is smaller in area than the first PCB module and does not cover the entire surface of the first PCB module.

The method may comprise connecting the first and second PCB modules by soldering e.g. by means of BGA ball connections.

It should be noted that the above mentioned aspects for a printed circuit board device are applicable for the suggested manufacturing method as well. Thus, all aspects disclosed for embodiments of the device can be combined with the suggested method to achieve similar effects and advantages.

These and other aspects of the invention will be apparent from and elucidated with reference to the embodiments described hereinafter, by way of example, with reference to the drawings.

### Detailed description

Various aspects are explained below in an exemplary manner with reference to the accompanying drawings, wherein:
Fig. 1 shows a prior art PCB device with high speed signal trace routing;
Fig. 2 shows a PCB device according to an embodiment;
Fig. 3 shows a bottom view of a PCB device according to an embodiment
Fig. 4 shows an embodiment of a second PCB module; and
Fig. 5 shows a further embodiment of a PCB device.

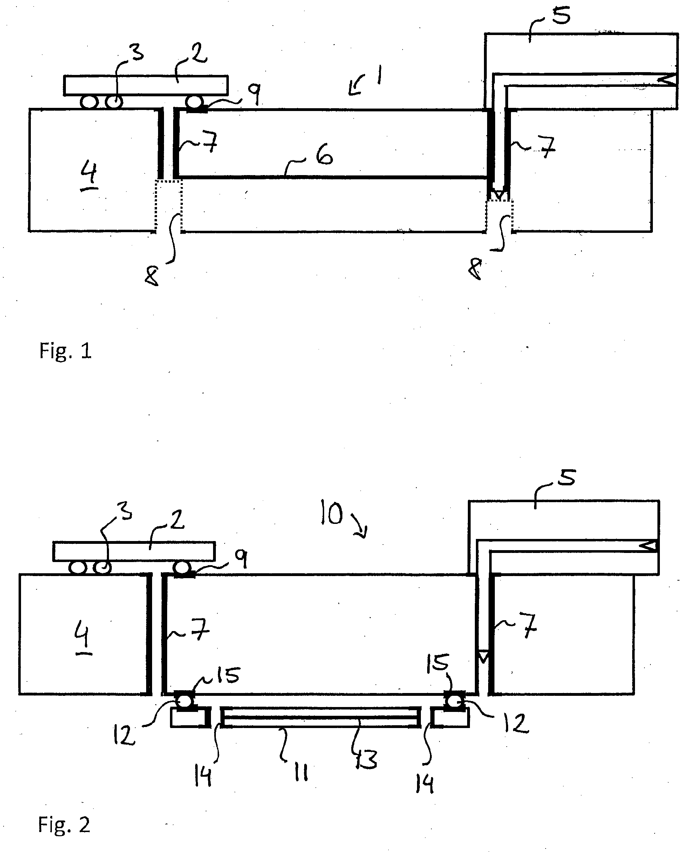

The printed circuit board (PCB) device 1 of Fig. 1 is provided with a first electrical component 2, which is connected via a ball grid array (BGA) 3 to a PCB module 4 of the PCB device 1. In the example shown in Fig. 1, the first electrical component 2 is a signal processing IC which is connected to the PCB module 4 via the BGA 3 and via a BGA ball pad 9 located on a surface of the PCB module 4. A second electrical component 5 is also provided on and connected to the PCB module 4. In the example shown in Fig. 1, the second electrical component 5 is a high speed connector which may form an electrical interface to a further circuit board or to a backplane.

High speed data signals, e.g. at data rates of at least 1 Gbit/s, are routed between the first and second electrical components 2,5 along a trace route 6 which is located in a layer inside the bulk of the multi-layer PCB module 4. In the schematic view of Fig. 1, only one trace route on one layer of the PCB module 4 is shown, but it is to be understood that, in general, a large number of trace routes are provided on different layers of the multilayer PCB module 4.

Via connections 7 are provided for interconnection with the signal layer of the PCB module 4 containing the trace route 6 to the respective electrical components 2, 5, which are located on a surface of the PCB module 4. Via stubs 8 are parts of the via holes 7 which extend beyond the trace route 6 and which are not required for data transmission via the trace route 6. In order to guarantee the high speed performance of the signal trace 6, the unused via stubs 8 have been removed by back drilling (indicated as a dotted line in Fig. 1) The need for back drilling generally increases the manufacturing cost and complexity of a PCB device.

The dielectric constant of the PCB substrate material is usually frequency dependent. In addition, the substrate material generally has other frequency dependent properties which influence the quality of the transmission performance of the traces, like e.g. dielectric losses or a damping factor. Thus, for the PCB module 4 as shown in Fig. 1, expensive special substrate materials may be necessary to avoid negative impacts of the substrate material on the performance of the high speed trace route 6, further increasing the manufacturing cost and complexity of the prior art PCB device 1.

In a typical PCB device 1, only a small proportion of all electrical nets are used for high speed data routing. This may mean that because of e.g. only 2.5% of the total number of electrical nets which are used for high speed data transfer, the whole multilayer PCB module may be built using costly high speed PCB substrate material. Thus, the provision of high speed electrical nets substantially increases the manufacturing cost of the prior art PCB device 1.

Fig. 2 shows a PCB device 10 according to an embodiment which overcomes the drawbacks of state of the art signal routing techniques. In addition to the parts and components described above in conjunction with the PCB device 1 of Fig. 1, which are designated with the same reference numbers as the corresponding elements of Fig. 1, the PCB device 10 comprises a high speed routing module (HSRM) 11, which is electrically connected, e.g. via respective ball grid arrays 12, to the first PCB module 4 and which comprises, in the present embodiment, a high speed trace route 13. The HSRM 11 may be adapted to provide a portion or even all of the high speed electrical nets of the PCB device 10, so that the first PCB module 4 may be manufactured without the need for expensive high frequency substrate materials or other design considerations which are necessary for the provision of high speed electrical nets.

Thus, all or at least some of the cost adders of the prior art PCB device may be transferred to the HSRM 11, which is much smaller than the first PCB module 4 and which is thus less costly to manufacture. The cost adders can be scaled in this way by applying them only to the high speed nets provided in the separate HSRM 11 and not to the overall number of nets. During design of the HSRM 11, the high frequency related performance of the high speed traces can be optimized without the need to balance the high speed performance against the requirements of neighboring low-speed and/or high current electrical nets.

The HSRM 11 may be provided with via holes 14 in order to connect the trace route 13 to a BGA 12 for electrical connection to a BGA ball pad 15 on the first PCB module 4. Alternatively, the respective BGAs 12 may be provided on the first PCB module 4 and the BGA ball pads 15 may be provided on the HSRM 11. Since the overall thickness of the HSRM 11 may be fairly low, e.g. around 0.8 mm, it is generally unnecessary to provide back drilling for these short via holes 14, thus further reducing the manufacturing cost and complexity of the HSRM 11.

Additionally, since the signals are routed from and to the electrical components 2,5 through the complete first PCB module 4, the via holes 7 provided in the first PCB module do not have any via stubs 8 extending beyond the signal trace. Thus, there is no need for costly back drilling techniques when manufacturing the first PCB module 4.

As shown in Fig. 2, the HSRM 11 may be provided on a bottom side of the first PCB module 4 which is opposite to the top side on which the electrical components 2, 5 are provided. Thus, one complete side of the first PCB module 4 is available for fitting bulky electrical components or for fitting electrical components with a large height dimension, while the slim HSRM 11 only marginally increases the overall dimensions of the PCB device 10 on the other surface. The PCB device 10 according to the present embodiment can still e.g. be fitted into a defined slot inside a telecommunications equipment.

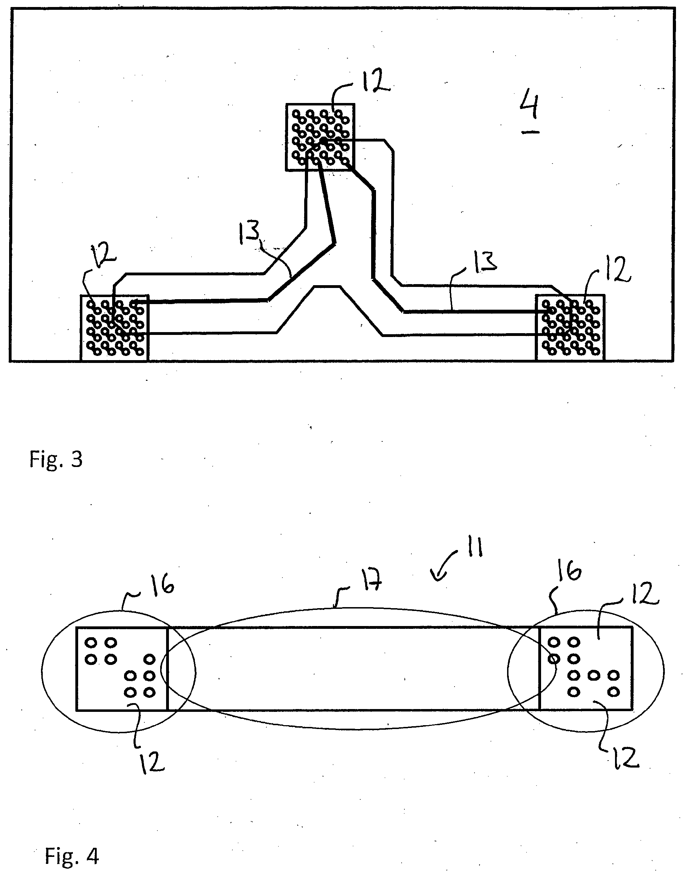

Fig. 3 shows a bottom view of the PCB device of Fig. 2. Therein, it can be seen that, according to embodiments, the HRSM 11 may be shaped so that it provides a trace route 13 between at least two specific portions of the first PCB module 4, wherein respective BGA connections 12 may be provided at each end of a trace route 13 provided by the HSRM 11

At the same time, the surface area of the HSRM 11 has been minimized and the HSRM 11 is provided to be as small as possible, substantially only extending along the trace routes. Thus, a large portion of the bottom surface area of the first PCB module 4 is available for connecting and mounting external components. Thus, the provision of the HSRM 11 on one side of the first PCB module 4 does not preclude other electrical components (not shown in Fig. 3) being provided on the underside of the PCB module 4 as the HSRM 11 only covers a small portion of the bottom surface area of the first PCB module 4. It is noted that, in general, for ease of manufacturing the solder connections between the PCB module 4 and the electrical components 2,5 mounted thereon, most electrical components will be located on the same side, designated as the top side in the present description, of the multilayer PCB module 4.

As shown in Fig. 4, according to embodiments, the HSRM 11 may comprise at least two connection portions 16 each comprising a BGA 12 and each located at a respective end of a routing portion 17 for routing signals between the connection portions 16. Alternatively, the respective BGA for connecting the PCB modules 4 and the HSRM 11 may be provided on the PCB module 4, and the connection portions of the HSRM 11 may comprise respective ball pads for connecting to the BGA on the PCB module 4. The routing portion 17 may comprise several individual trace routes 13.

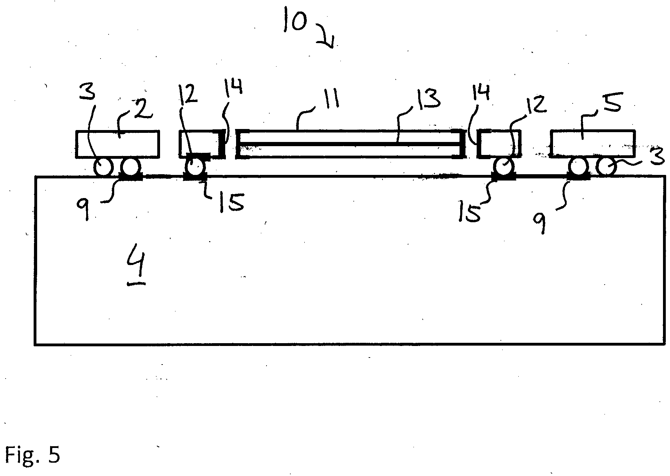

Fig. 5 shows a further embodiment of a PCB device 10, wherein the HSRM 11 is located on the same side of the first PCB module 4 as the electrical components 2,5. Thus, according to this embodiment, no via connections through the first PCB module 4 are necessary for routing signals from the first electrical component 2 along a trace 13 provided in the HSRM 11 to the second electrical component 5.

In the example shown in Fig. 5, the second electrical component 5 is a further signal processing IC, which is connected to the first PCB module 4 via a BGA 3 and a BGA ball pad 9, similar to the first electrical component 2.

An example for the layer composition and layout of a HSRM 11 is given in the table below:

| Layer # | Usage | Material | Data sheet [µm] | Thickness after processing and lamination [µm] |
|---|---|---|---|---|
| | | | | |
| | | Solder Mask TOP | | 18 |
| | | | | |
| 1 | GND | 1/2oz. copper foil, std. | 17,5 | 55 |
| | | | | |
| | | Prepreg | 200 | 188 |
| | | | | |
| 2 | HS-1: TX | 1/2oz. copper, H-VLP | 17,5 | 15 |
| | | Core | 200 | 200 |
| 3 | GND | 1/2oz. copper foil, std. | 17,5 | 15 |
| | | | | |
| | | Prepreg | 200 | 198 |
| | | | | |
| 4 | connector PAD/GND | 1/2oz. copper foil, std. | 17,5 | 55 |
| | | | | |
| | | Solder Mask BOTTOM | | 18 |

Thus, the total thickness (incl. soldermask) of the above-listed example HSRM, is 762 µm, wherein the manufacturing tolerance is typically in the region of +/-10%. The expected substrate to substrate thickness of the above-listed example HSRM is 671 µm +/- 10%.

In the present example, three ground layers GND are provided, indicated as layers No 1, 3 and 4. Layer No 2 provides high speed data trace routes. Connection portions for connecting the HSRM 11 to the first PCB module 4, as described above, may e.g. be provided on layer No 4. As a possible modification, a HSRM 11 with only two ground layers GND and a high speed data transfer layer could be provided. Even with the three ground layers as shown in the above table, it is noted that the example HSRM 11 only comprises 4 conductive layers and is less than 0.8 mm thick, as compared to typically 16-24 layers of a multilayer PCB module 4 with a thickness of typically 1.5- 3 mm. The non-conductive layers may be manufactured from a high speed/low loss substrate material, wherein the material properties are substantially constant even at high frequencies. Due to the limited number of layers and the small size of the HSRM 11, even the use of more costly substrate materials does not significantly increase the overall manufacturing cost of the PCB device, while ensuring a high signal quality at signal frequencies greater than 1 GHz and/or data rates greater than 1Gbit/s in the HSRM 11.

The various embodiments of the present device and method provide a dedicated high speed routing module which is especially designed in order to route the high speed traces only. Hence, the high speed routing networks are removed from the first PCB module 4, so that the number of layers at the first PCB module 4 can be reduced when compared to a PCB module that comprises the high speed routing networks as well as all of the other electrical routing networks. Further, the first PCB module 4 can be manufactured using a standard substrate material which reduces the manufacturing cost of the first PCB module.

According to embodiments, neither the dedicated HSRM 11 nor the first PCB module 4 require back drilling, as the thickness of the HSRM 11 is very low and as the first PCB module 4 may have only few, if any, high speed nets. Signal integrity is thus improved, as via stubs are negligible. There is a straight forward routing path available from signal source to sink, via the HSRM 11, with minimized impedance discontinuity. Hence, transmission performance of the routing path via the HSRM 11 is significantly improved.

A single HRSM 11 can be used on several different PCB devices 10 under the SSS (Same BGA device, Same backplane connector, Same placement) condition, thus ensuring constant signal integrity for high speed signals for all these different PCB devices 10.

As a possible modification, ultra high complexity PCB devices could be enabled, even if the layer number of the first PCB module is limited with regard to a maximum desirable board thickness and aspect ratio. In other words, the reduction of the layer count on the first PCB module, as high speed traces have been transferred to the HSRM, does not only save cost in manufacturing the first PCB module, but could be used on the other hand to add more complexity to the first PCB module. This could enable more complex designs.

The provision of a dedicated HSRM further enables ultra high speed transmission over longer distances, as the best available high frequency substrate material can now be used for stacking-up the HSRM, while still achieving a low overall manufacturing cost of the PCB device.

When compared to the prior art PCB device as shown in Fig. 1, the high speed trace of the PCB device 10 according to embodiments has been moved from the inner layer of the first PCB module 4 to an inner layer of the HSRM 11. The HSRM 11 is placed on the bottom side of the first PCB module 4, just like a regular electrical component. It can be clearly seen that via stubs have been removed from the first PCB module 4, but have been transferred to the HSRM 11 for connecting the trace route in the HSRM 11 to the BGA pads of the HSRM 11. However, on the HSRM 11, the via stub is significantly smaller as on the first PCB module 4, and thus back drilling may be unnecessary for the via stubs of the HSRM 11.

However it should be noted, that the provision of a dedicated second PCB module, as described above for a HSRM as an example embodiment, could also be applied to signals below a data rate of 1Gbit/s. According to modifications, a separate second PCB module as described above could e.g. be applied to static or to high current nets, as used for supplying power to electrical components mounted on the first PCB module.

It should be noted that the description and drawings merely illustrate the principles of the proposed methods and devices. It will thus be appreciated that those skilled in the art will be able to devise various arrangements that, although not explicitly described or shown herein, embody the principles of the invention and are included within its spirit and scope. Furthermore, all examples recited herein are principally intended expressly to be only for pedagogical purposes to aid the reader in understanding the principles of the proposed methods and systems and the concepts contributed by the inventors to furthering the art, and are to be construed as being without limitation to such specifically recited examples and conditions. Moreover, all statements herein reciting principles, aspects, and embodiments of the invention, as well as specific examples thereof, are intended to encompass equivalents thereof.

Finally, it should be noted that any block diagrams herein represent conceptual views of illustrative circuitry embodying the principles of the invention. Similarly, it will be appreciated that any flow charts, flow diagrams, state transition diagrams, pseudo code, and the like represent various processes which may be substantially represented in computer readable medium and so executed by a computer or processor, whether or not such computer or processor is explicitly shown.

## Claims

1. Printed circuit board, PCB, device, comprising:
- a first PCB module,
- a second PCB module, and
- at least two electrical components mounted on the first PCB module,
wherein a signal from a first one of the electrical components to a second one of the electrical components is routed via the second PCB module.

2. PCB device according to claim 1, wherein the first and the second PCB module are parallel to each other.

3. PCB device according to claim 1 or 2, wherein the at least two electrical components are positioned on a first side of the first PCB module and wherein the second PCB module is positioned on a second side of the PCB module opposite the first side.

4. PCB device according to claim 1 or 2, wherein the at least two electrical components are positioned on a first side of the first PCB module and wherein the second PCB module is positioned on the first side of the PCB module.

5. PCB device according to any one of claims 1, 3 or 4, wherein the second PCB module is flexible and curved relative to a surface of the first PCB module.

6. PCB device according to any one of claims 1 to 5, wherein the second PCB module comprises a different substrate material than the first PCB module.

7. PCB device according to any one of claims 1 to 6, wherein the second PCB module is adapted for routing signals with a data rate of at least 1 Gbit/s and/or for routing signals with a frequency content of at least 1GHz.

8. PCB device according to any one of claims 1 to 7, wherein the second PCB module comprises fewer layers than the first PCB module.

9. PCB device according to claim 8, wherein the second PCB module has an overall thickness of less than 1 mm.

10. PCB device according to claim 9, wherein the second PCB module comprises less than 10 layers.

11. PCB device according to any one of claims 1 to 10, wherein the signal from the first to the second electrical component is routed along a first via connection through the first PCB module from the first electrical component to the second PCB module and is routed along a second via connection through the first PCB module from the second PCB module to the second electrical component.

12. PCB device according to any one of claims 1 to 11, wherein the second PCB module comprises at least two connection portions for connecting the second PCB module to the first PCB module.

13. PCB device according to claim 12, wherein the at least two connection portions connect the second PCB module to the first PCB module via BGA ball connections.

14. PCB device according to any one of claims 1 to 13, wherein the second PCB module is provided with at least two connection portions and at least one routing portion for routing signals from a first connection portion to a second connection portion.

15. Method for manufacturing a printed circuit board device, comprising:
- providing a first and a second PCB module,
- connecting the second PCB module to the first PCB module,
- mounting at least two electrical components on the first PCB module,
- providing a trace for routing a signal from a first one of the electrical components to a second one of the electrical components via the second PCB module.

## Amended claims

### Amended claims in accordance with Rule 137(2) EPC.

1. Printed circuit board, PCB, device, comprising:
- a first PCB module,
- a second PCB module comprising a plurality of layers, and
- at least two electrical components mounted on the first PCB module,
wherein a signal from a first one of the electrical components to a second one of the electrical components is routed via a high speed trace route of the second PCB module,
wherein the first PCB module and the second PCB module are connected by soldering, and
wherein the high speed trace route is in an inner layer of the second PCB module.

2. PCB device according to claim 1, wherein the first and the second PCB module are parallel to each other.

3. PCB device according to claim 1 or 2, wherein the at least two electrical components are positioned on a first side of the first PCB module and wherein the second PCB module is positioned on a second side of the PCB module opposite the first side.

4. PCB device according to claim 1 or 2, wherein the at least two electrical components are positioned on a first side of the first PCB module and wherein the second PCB module is positioned on the first side of the PCB module.

5. PCB device according to any one of claims 1, 3 or 4, wherein the second PCB module is flexible and curved relative to a surface of the first PCB module.

6. PCB device according to any one of claims 1 to 5, wherein the second PCB module comprises a different substrate material than the first PCB module.

7. PCB device according to any one of claims 1 to 6, wherein the second PCB module is adapted for routing signals with a data rate of at least 1 Gbit/s and/or for routing signals with a frequency content of at least 1GHz.

8. PCB device according to any one of claims 1 to 7, wherein the second PCB module comprises fewer layers than the first PCB module.

9. PCB device according to claim 8, wherein the second PCB module has an overall thickness of less than 1 mm.

10. PCB device according to claim 9, wherein the second PCB module comprises less than 10 layers.

11. PCB device according to any one of claims 1 to 10, wherein the signal from the first to the second electrical component is routed along a first via connection through the first PCB module from the first electrical component to the second PCB module and is routed along a second via connection through the first PCB module from the second PCB module to the second electrical component.

12. PCB device according to any one of claims 1 to 11, wherein the second PCB module comprises at least two connection portions for connecting the second PCB module to the first PCB module.

13. PCB device according to claim 12, wherein the at least two connection portions connect the second PCB module to the first PCB module via BGA ball connections.

14. PCB device according to any one of claims 1 to 13, wherein the second PCB module is provided with at least two connection portions and at least one routing portion for routing signals from a first connection portion to a second connection portion.

15. Method for manufacturing a printed circuit board device, comprising:
- providing a first and a second PCB module, the second PCB module comprising a plurality of layers,
- connecting the second PCB module to the first PCB module by soldering,
- mounting at least two electrical components on the first PCB module,
- providing a trace for routing a signal from a first one of the electrical components to a second one of the electrical components via a high speed trace route of the second PCB module, wherein the high speed trace route is in an inner layer of the second PCB module.
